# EUROPEAN PATENT APPLICATION

(11) **EP 4 404 703 A1**
(43) Date of publication of application: **24.07.2024**
(21) Application number: 23201786.3
(22) Date of filing: 05.10.2023
(51) Int. Cl.: H05K 7/20

(54) **OUTDOOR CABINET WITH PROTECTIVE DAMPER**

(30) Priority: 17.01.2023 US 202363439318 P; 30.06.2023 CN 202310801788
(71) Applicant: Delta Electronics, Inc., Taoyuan City 33370 (TW)
(72) Inventor: Wu, Kuan-Lung, 32063 Taoyuan City (TW); Liu, Pi-Chen, 32063 Taoyuan City (TW); Chen, Chia-Hsing, 32063 Taoyuan City (TW); You, Siang-Lin, 32063 Taoyuan City (TW)
(74) Representative: Uexküll & Stolberg

(57) **Abstract**

An outdoor cabinet (1) is disclosed and includes a cabinet (10), an active damper (3) and a passive damper (2, 2a, 2b, 2c). The cabinet (10) includes an air inlet (12), an air outlet (13) and an accommodation space (11). The accommodation space (11) is in communication with an outdoor environment through the air inlet (12) and the air outlet (13), respectively. The active damper (3) is arranged adjacent to the air inlet (12). The passive damper (2, 2a, 2b, 2c) includes an exhaust fan (40) and a damper blade (21). The exhaust fan (40) is arranged adjacent to the air outlet (13). The damper blade (21) is arranged between the air outlet (13) and the outdoor environment. When the exhaust fan (40) is in operation, the damper blade (21) allows a heat-dissipation airflow (F1) to be discharged from the air outlet (13) to the outdoor environment. When a wind pressure of the outdoor environment is greater than a wind pressure of the accommodation space (11), the damper blade (21) closes the air outlet (13) to protect electronic devices (9) installed in the cabinet (10).

## Description

### FIELD OF THE INVENTION

The present disclosure relates to an outdoor cabinet, and more particularly to an outdoor cabinet with a passive damper served as a protective damper for maintaining the heat-dissipation airflow volume of the cabinet during normal use, and completely preventing the storm from pouring back under the wind-driven rain weather conditions.

### BACKGROUND OF THE INVENTION

In order to protect the power supply equipment from the sun, heat radiation, rain and air, and achieve the functions of waterproof, moisture-proof, dustproof and corrosion resistance, an outdoor cabinet is used to provide a proper protection for the power supply equipment when the power supply equipment is accommodated therein. In that, the life and the normal operation of the power supply equipment can be maintained. Furthermore, in order to dissipate the heat generated by the power supply equipment in the cabinet, the outdoor cabinet needs to be in communication with the outdoor environment through an air-cooled cooling system to exert heat dissipation performance. However, in view of the changing state of the outdoor environment, the outdoor cabinet must provide the necessary protection level to avoid the internal electronic devices from damage.

For dealing with the wind-driven rain weather conditions, some conventional outdoor cabinets have the waterproof air filters disposed thereon to prevent the wind and rain from entering the cabinets. However, waterproof air filters are too expensive to increase the cost, and the waterproof air filters greatly reduce the heat-dissipation airflow volume of the cabinets. On the other hand, some conventional outdoor cabinets also use a fixed waterproof structure to prevent the wind and rain from entering the cabinet, but the waterproof performance cannot achieve a complete weatherproof effect, and it will also greatly reduce the heat-dissipation airflow volume of the cabinet.

In view of this, there is a need of providing an outdoor cabinet with a passive damper served as a protective damper for maintaining the heat-dissipation airflow volume of the cabinet during normal use, and completely preventing the storm from pouring back under the wind-driven rain weather conditions, so as to obviate the drawbacks encountered by the prior arts.

### SUMMARY OF THE INVENTION

An object of the present disclosure is to provide an outdoor cabinet with a protective damper. A passive damper is disposed adjacent to the air outlet of the outdoor power-supply air-cooled cooling cabinet. During normal use, the passive damper is opened to maintain the heat-dissipation airflow of the cabinet. Under the wind-driven rain weather conditions, the passive damper is closed by the wind pressure, so as to provide the protection and completely prevent the storm from pouring back to the air outlet or entering the cabinet.

Another object of the present disclosure is to provide an outdoor cabinet with a protective damper. With a passive damper disposed in the air-guiding channel communicated up and down, the heat-dissipation airflow volume is sufficiently maintained during normal use, and 100% blocking of the storm is ensured to prevent the storm from pouring back to the air outlet or entering the cabinet under the wind-driven rain weather conditions. The passive damper blade can be installed through a hollow frame or directly installed in the air-guiding channel. There is no need to use other waterproof air filters to prevent the storm from pouring back. Consequently, the installation is simplified and the design cost is reduced. On the other hand, since the damper blade is installed and pivoted to the air-guiding channel through ball bearings or pin bearings, it allows to keep the end edge of the damper blade saggy within a specific angle range by using the force of gravity and cooperating with the limit columns. In this way, the internal heat-dissipation airflow can flow through the damper blade smoothly. Compared with the conventional complex fixed structure for preventing the storm from pouring back through the vent, the passive damper of the present disclosure is disposed in the air-guiding channel to keep open during normal use, without increasing the air pressure drop, so that the heat-dissipation airflow is maintained at a high flow rate. Moreover, under the wind-driven rain weather conditions, the wind pressure in the outdoor environment is greater than the wind pressure in the cabinet and a reverse airflow is generated to flow from the outdoor environment through the vents and enters the air-guiding channel. In this way, the reverse airflow can easily drive the damper blade to close the air-guiding channel, and the effect of completely preventing the storm from pouring back to the air outlet through the vents or entering the cabinet is achieved.

In accordance with an aspect of the present disclosure, an outdoor cabinet with a protective damper is provided and includes a cabinet, an active damper and a passive damper. The cabinet is set on a horizontal ground. The cabinet includes an air inlet and an air outlet corresponding to each other, wherein the air inlet is disposed on a first cabinet lateral wall of the cabinet, the air outlet is disposed on a second cabinet lateral wall of the cabinet, and the first cabinet lateral wall and the second cabinet lateral wall are corresponding to each other. The first cabinet lateral wall and the second cabinet lateral wall are perpendicular to the horizontal ground. The active damper is disposed on the first cabinet lateral wall and arranged adjacent to the air inlet. The passive damper is disposed on the second cabinet lateral wall and includes an exhaust fan and a damper blade. The exhaust fan is disposed adjacent to the air outlet, and the damper blade is disposed outside the air outlet for closing or opening the air outlet. The exhaust fan is operated to generate a heat-dissipation airflow flowing inside the cabinet from the air inlet to the air outlet, and the damper blade allows the heat-dissipation airflow to be discharged from the air outlet. When a wind pressure outside the cabinet is greater than a wind pressure inside the cabinet and a reverse airflow is generated, the reverse airflow drives the damper blade to close the air outlet for protecting electronic devices installed in the cabinet.

In accordance with another aspect of the present disclosure, an outdoor cabinet with a protective damper is provided and includes a cabinet, an active damper, a cover and a passive damper. The cabinet includes a first cabinet lateral wall and a second cabinet lateral wall corresponding to each other, an air inlet, an air outlet and an accommodation space, wherein the air inlet is disposed on the first cabinet lateral wall, the air outlet is disposed on the second cabinet lateral wall, and the accommodation space is in communication with the air inlet and the air outlet. The active damper is disposed on the first cabinet lateral wall and configured to form a heat-dissipation airflow inhaled through the air inlet and discharged through the air outlet. The cover covers the air outlet and collaboratively forms an air-guiding channel with the second cabinet lateral wall, wherein the air-guiding channel is communicated up and down, and includes an upper part of the air-guiding channel in communication with the accommodation space through the air outlet, and a lower part of the air-guiding channel in communication with an outdoor environment through a vent. The passive damper is disposed in the air-guiding channel, and includes a hollow frame a damper blade. The hollow frame is communicated up and down, and includes a frame front wall, a frame rear wall and two opposite frame lateral walls attached to an inner wall surface of the air-guiding channel, respectively. The damper blade includes a pivoted portion, a first end edge and a second end edge, wherein the damper blade is pivotally arranged between the two opposite frame lateral walls through the pivoted portion, and the first end edge and the second end edge are located at two opposite sides of the pivoted portion, respectively, wherein the first end edge is spatially corresponding to the frame front wall, the second end edge is spatially corresponding to the frame rear wall, and the first end edge and the second end edge have different torques relative to the pivoted portion, wherein when a wind pressure of the outdoor environment is greater than a wind pressure of the accommodation space and a reverse airflow is generated to flow from the outdoor environment into the air-guiding channel, the reverse airflow drives the damper blade to rotate, the first end edge is driven to abut against the frame front wall, and the second end edge is driven to abut against the frame rear wall, so as to close the air-guiding channel.

In accordance with a further aspect of the present disclosure, an outdoor cabinet with a protective damper is provided and includes a cabinet, an active damper, a cover and a passive damper. The cabinet includes a first cabinet lateral wall and a second cabinet lateral wall corresponding to each other, an air inlet, an air outlet and an accommodation space, wherein the air inlet is disposed on the first cabinet lateral wall, the air outlet is disposed on the second cabinet lateral wall, and the accommodation space is in communication with the air inlet and the air outlet. The active damper is disposed on the first cabinet lateral wall and configured to form a heat-dissipation airflow inhaled through the air inlet and discharged through the air outlet. The cover is connected to the second cabinet lateral wall, covers the air outlet and collaboratively forms an air-guiding channel with the second cabinet lateral wall, wherein the air-guiding channel is communicated up and down, and includes an upper part of the air-guiding channel in communication with the accommodation space through the air outlet, and a lower part of the air-guiding channel in communication with an outdoor environment through a vent, wherein the cover includes a cover rear lateral wall and two opposite cover lateral walls, and the cover is connected to the second cabinet lateral wall through the two opposite cover lateral walls, respectively. The passive damper includes a damper blade, a pivoted portion, a first end edge and a second end edge, wherein the damper blade is pivotally arranged between the two opposite cover lateral walls through the pivoted portion, and the first end edge and the second end edge are located at two opposite sides of the pivoted portion, respectively, wherein the first end edge is spatially corresponding to the second cabinet lateral wall, the second end edge is spatially corresponding to the cover rear wall, and the first end edge and the second end edge have different torques relative to the pivoted portion, wherein when a wind pressure of the outdoor environment is greater than a wind pressure of the accommodation space and a reverse airflow is generated to flow from the outdoor environment into the air-guiding channel, the reverse airflow drives the damper blade to rotate, the first end edge is driven to abut against the frame front wall, and the second end edge is driven to abut against the frame rear wall, so as to close the air-guiding channel.

### BRIEF DESCRIPTION OF THE DRAWINGS

The above contents of the present disclosure will become more readily apparent to those ordinarily skilled in the art after reviewing the following detailed description and accompanying drawings, in which:
FIG. 1 is a schematic structural view illustrating an outdoor cabinet with a protective damper according to an embodiment of the present disclosure;
FIG. 2 is a partially exploded view illustrating the outdoor cabinet with the protective damper according to the embodiment of the present disclosure;
FIG. 3 is a vertically cross-sectional view illustrating the outdoor cabinet with the protective damper according to the embodiment of the present disclosure;
FIG. 4 is a schematic diagram showing the air-guiding channel operated in the normal use state according to the embodiment of the present disclosure;
FIG. 5 is a horizontally cross-sectional view illustrating the air-guiding channel operated in the normal use state according to the embodiment of the present disclosure;
FIG. 6 is a schematic structural view illustrating the passive damper operated in the normal use state according to the embodiment of the present disclosure;
FIG. 7 is a vertically cross-sectional view illustrating the passive damper operated in the normal use state according to the embodiment of the present disclosure;
FIG. 8 is a schematic diagram showing the air-guiding channel operated under the wind-driven rain weather conditions according to the embodiment of the present disclosure;
FIG. 9 is a horizontally cross-sectional view illustrating the air-guiding channel operated under the wind-driven rain weather conditions according to the embodiment of the present disclosure;
FIG. 10 is a schematic structural view illustrating the passive damper operated under the wind-driven rain weather conditions according to the embodiment of the present disclosure;
FIG. 11 is a vertically cross-sectional view illustrating the passive damper operated under the wind-driven rain weather conditions according to the embodiment of the present disclosure;
FIG. 12 is a vertically cross-sectional view illustrating a second exemplary passive damper operated in the normal use state according to the embodiment of the present disclosure;
FIG. 13 is a vertically cross-sectional view illustrating the second exemplary passive damper operated under the wind-driven rain weather conditions according to the embodiment of the present disclosure;
FIG. 14 is a vertically cross-sectional view illustrating a third exemplary passive damper operated in the normal use state according to the embodiment of the present disclosure;
FIG. 15 is a vertically cross-sectional view illustrating the third exemplary passive damper operated under the wind-driven rain weather conditions according to the embodiment of the present disclosure;
FIG. 16 is a vertically cross-sectional view illustrating a fourth exemplary passive damper operated in the normal use state according to the embodiment of the present disclosure; and
FIG. 17 is a vertically cross-sectional view illustrating the fourth exemplary passive damper operated under the wind-driven rain weather conditions according to the embodiment of the present disclosure.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed. Further, spatially relative terms, such as "upper," "lower," "top," "bottom," "front," "rear" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly. When an element is referred to as being "connected," or "coupled," to another element, it can be directly connected or coupled to the other element or intervening elements may be present. Although the wide numerical ranges and parameters of the present disclosure are approximations, numerical values are set forth in the specific examples as precisely as possible. In addition, although the "first," "second," "third," and the like terms in the claims be used to describe the various elements can be appreciated, these elements should not be limited by these terms, and these elements are described in the respective embodiments are used to express the different reference numerals, these terms are only used to distinguish one element from another element. For example, a first element could be termed a second element, and, similarly, a second element could be termed a first element, without departing from the scope of example embodiments.

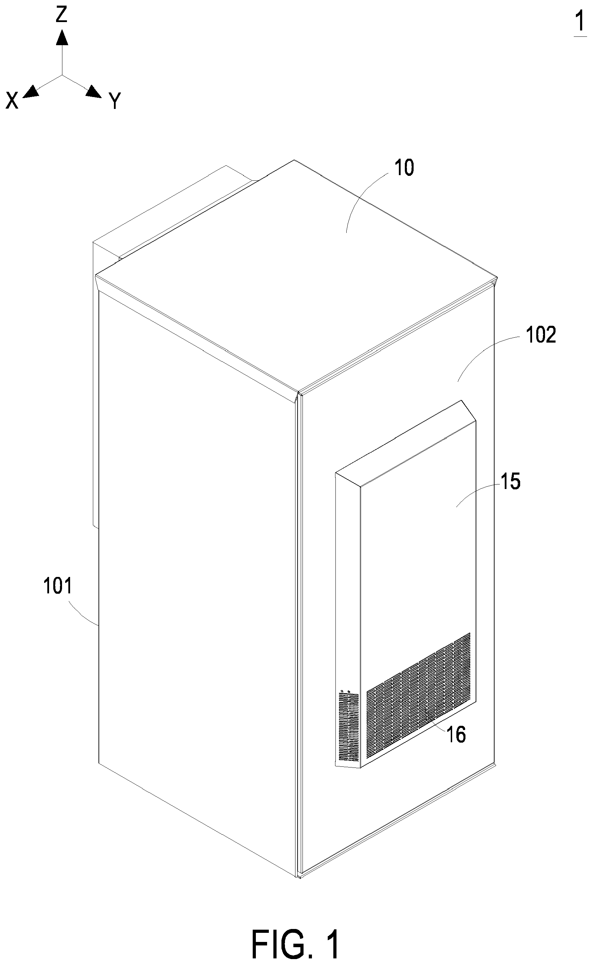

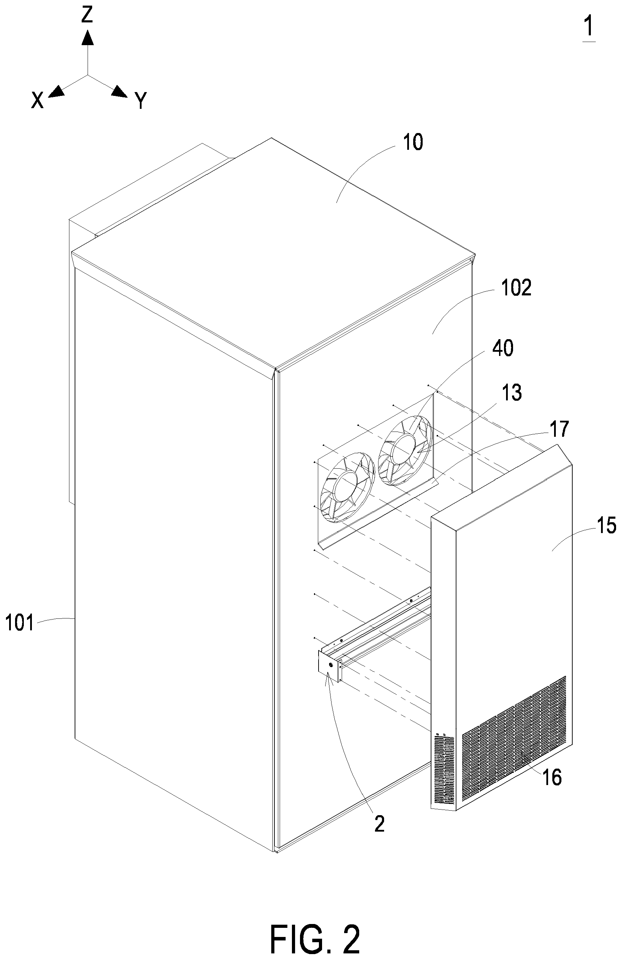

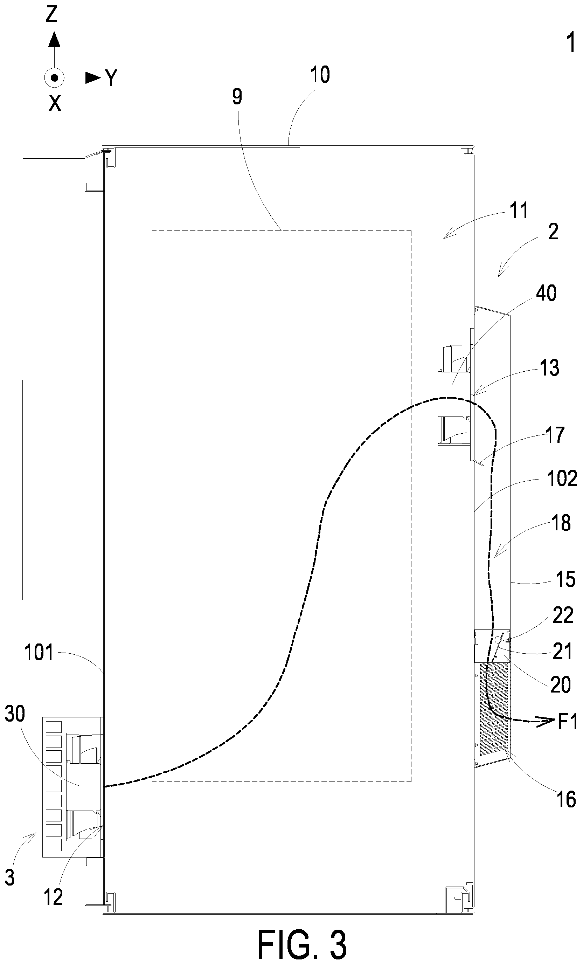

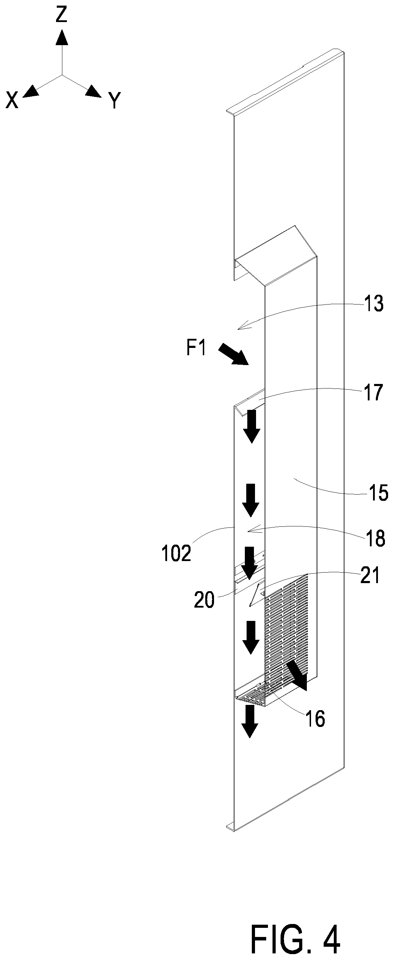

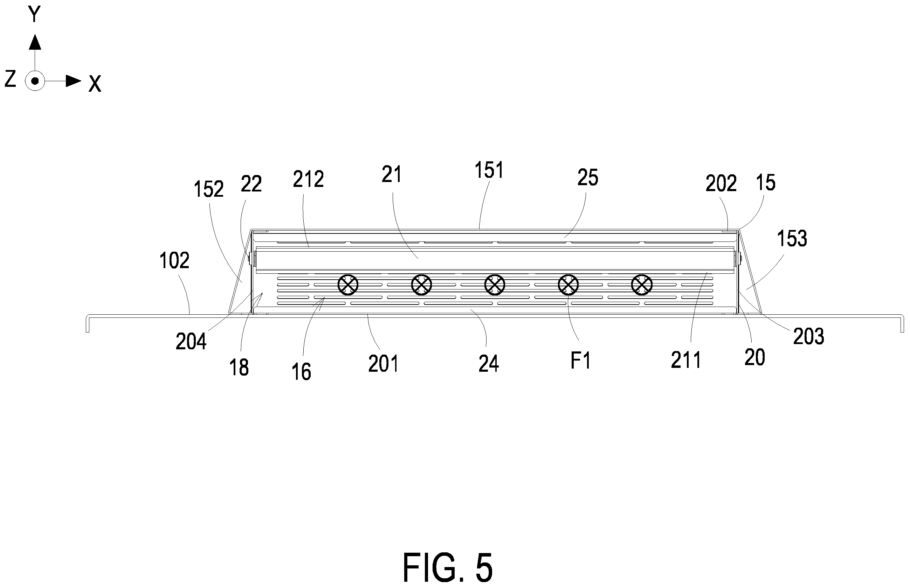

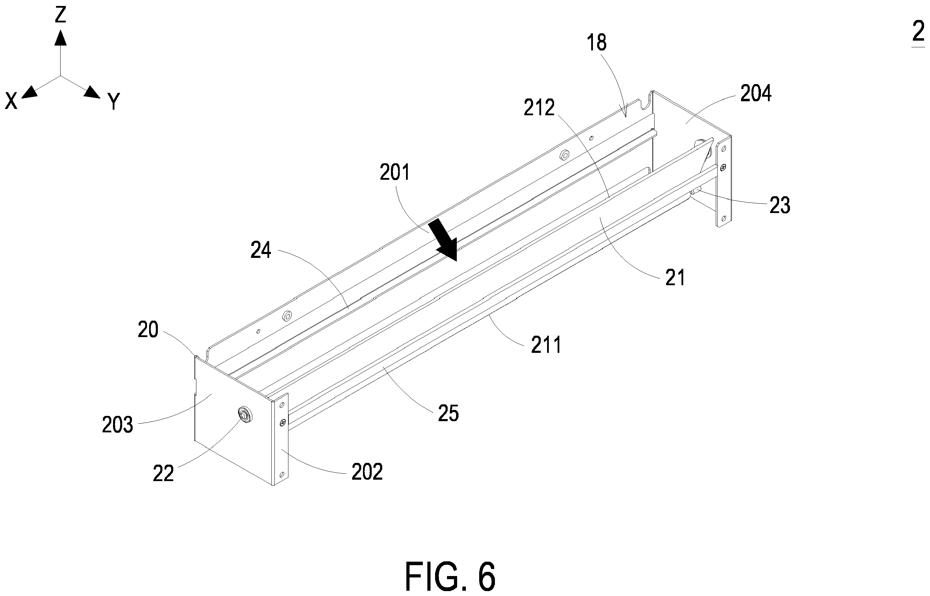

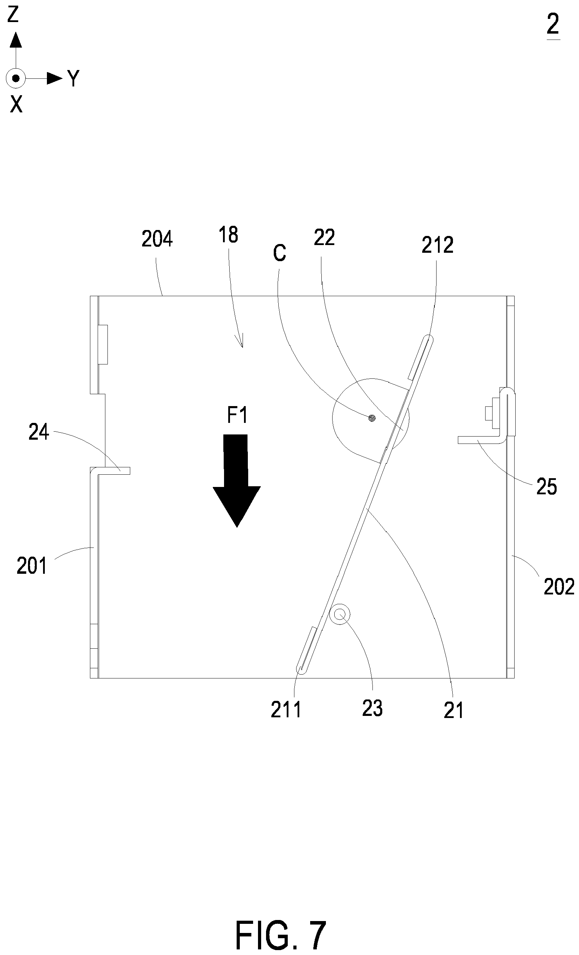

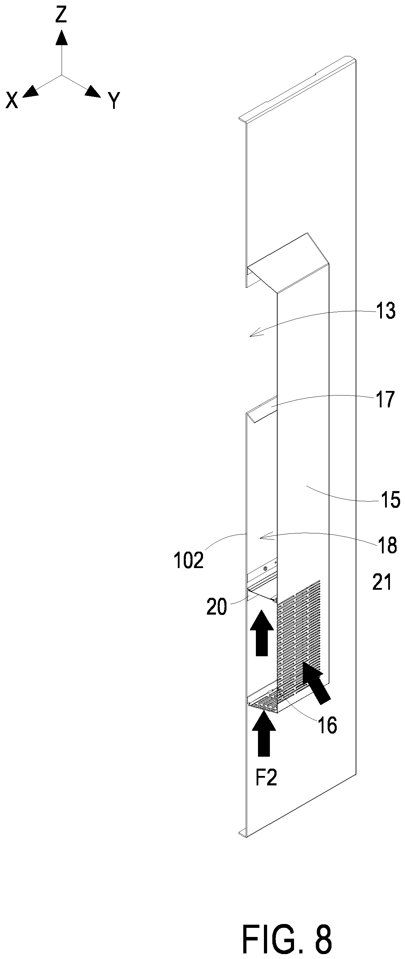

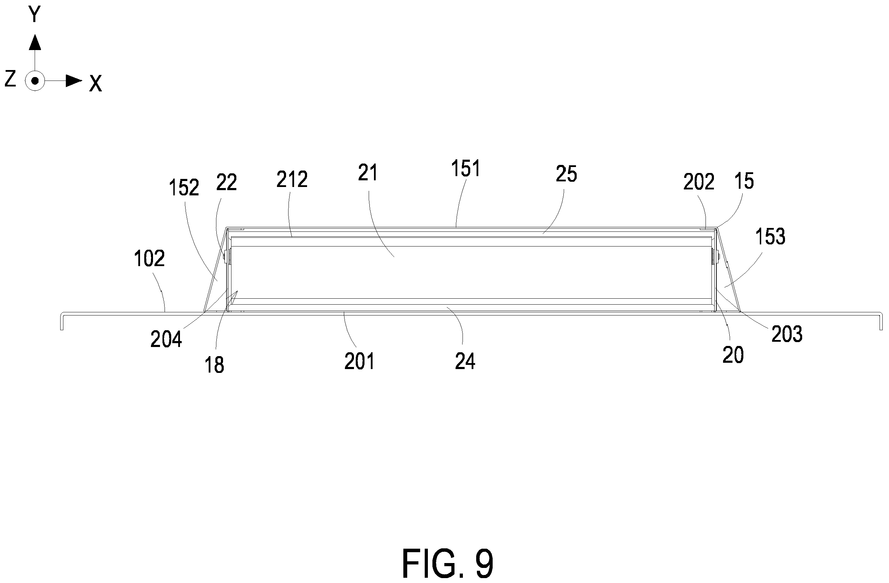

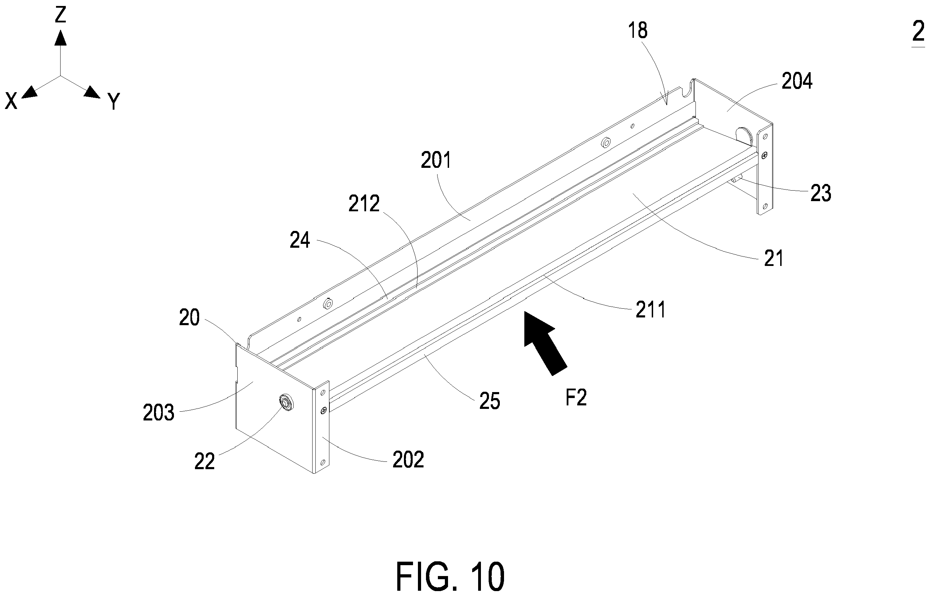

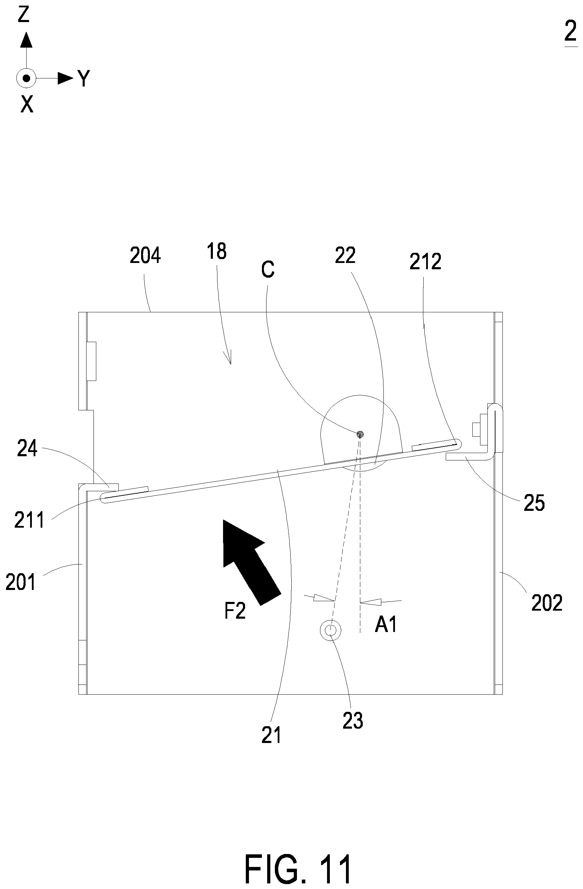

Please refer to FIG. 1 to FIG. 11. They illustrate an outdoor cabinet with a protective damper according to an embodiment of the present disclosure. In the embodiment, an outdoor cabinet 1 with a protective damper is provided and set on a horizontal ground in the XY plane. The outdoor cabinet 1 includes a cabinet 10, an active damper 3 and a passive damper 2. The cabinet 10 includes a first cabinet lateral wall 101 and a second cabinet lateral wall 102 corresponding to each other, an air inlet 12, an air outlet 13 and an accommodation space 11. In the embodiment, the air inlet 12 and the air outlet 13 are corresponding to each other, the air inlet 12 is disposed on the first cabinet lateral wall 101, and the air outlet 13 is disposed on the second cabinet lateral wall 102. The accommodation space 11 is in communication with an outdoor environment through the air inlet 12 and the air outlet, respectively, and configured to accommodate electronic devices 9. Preferably but not exclusively, in the embodiment, the first cabinet lateral wall 101 and the second cabinet lateral wall 102 are a front cabinet lateral wall and a rear cabinet lateral wall, respectively, and perpendicular to the horizontal ground in the XY plane. The active damper 3 is disposed on the first cabinet lateral wall 101 and includes an inflow fan 30. The inflow fan 30 and the air inlet 12 arranged adjacent to each other. The passive damper 2 is disposed on the second cabinet lateral wall 102 and includes an exhaust fan 40 and a damper blade 21. The exhaust fan 40 is disposed adjacent to the air outlet 13, and the air outlet 13 is in communication between the accommodation space 11 and the outdoor environment. In the embodiment, the damper blade 21 is disposed between the air outlet 13 and the outdoor environment for closing or opening the communication between the air outlet 13 and the outdoor environment. The position and the type of the inflow fan 30 and the air inlet of the active damper 3 are adjustable according to the practical requirements, so as to dissipate heat from the electronic devices 9 in the accommodation space 11. In the embodiment, the inflow fan 30 and the air inlet 12 are spatially corresponding to the exhaust fan 40 and the air outlet 13. Preferably but not exclusively, the inflow fan 30 and the exhaust fan 40 are operated to form a heat-dissipation airflow F1. The heat-dissipation airflow F1 is inhaled through the air inlet 12, flows through the accommodation space 11 for dissipating heat from the electronic devices 9 in the accommodation space 11, and then is discharged through the air outlet 13. In other embodiments, one of the inflow fan 30 and the exhaust fan 40 is omitted. Alternatively, an exhaust fan is additionally disposed in the cabinet 10. When the exhaust fan disposed in the cabinet 10 is operated, the heat-dissipation airflow is generated to flow in the cabinet 10. Notably, in the forgoing embodiment, the inflow fan 30 and the exhaust fan 40 are provided to increase the flow rate of the heat-dissipation airflow F1 in the accommodation space 11, so as to increase the heat dissipation efficiency. The form of cooling air intake and the control of the active damper 3 are not limited in the present disclosure, but the heat-dissipation airflow F1 in the accommodation space 11 can flow from the air inlet 12 to the air outlet 13, and the damper blade 21 allow the heat-dissipation airflow F1 to be discharged to the outdoor environment through the air outlet 13 and as shown in FIG. 4. Furthermore, under the wind-driven rain weather conditions, a wind pressure of the outdoor environment is greater than a wind pressure in the accommodation space 11 and a reverse airflow F2 is generated. The reverse airflow F2 drives the damper blade 21 to block the communication between the air outlet 13 and the outdoor environment for protecting the electronic devices 9 installed in the cabinet 10. The action of the damper blade 21 in the passive damper 2 will be further described below.

In the embodiment, the outdoor cabinet 1 further includes a cover 15 disposed on the cabinet 10 for setting the damper blade 21 of the passive damper 2. The cover 15 has the lateral edges connected to the second cabinet lateral wall 102 and covers the air outlet 13 of the cabinet 10. Moreover, an air-guiding channel 18 is collaboratively formed between the cover 15 and the second cabinet lateral wall 103. In the embodiment, the cabinet 10 further includes a deflector 17. The deflector 17 is connected to a lower edge of the air outlet 13, protrudes toward the air-guiding channel 18, and forms an acute angle with the second cabinet lateral wall 102. In that, the deflector 17 is configured to guide the heat-dissipation airflow F1 into the air-guiding channel 18. In the embodiment, the air-guiding channel 18 is disposed upwardly and downwardly in fluid communication. That is, an upper part of the air-guiding channel 18 is in communication with the accommodation space 11 through the air outlet 13, and a lower part of the air-guiding channel 18 is in communication with an outdoor environment through a vent 16. A horizontal height of the air outlet 13 higher than a horizontal height of the vent 16 in the Z axial direction. In the embodiment, the cover 15 has the opening facing the second cabinet lateral wall 102. In addition to the top wall and the bottom wall, the cover 15 further includes a cover rear lateral wall 151 and two opposite cover lateral walls 152, 153, and the cover 15 is connected to the second cabinet lateral wall 102 through the top wall, the bottom wall and the two opposite cover lateral walls 152, 153, respectively. In other words, the air-guiding channel 18 formed between the air outlet 13 and the vent 16 is surrounded by the second cabinet lateral wall 102, the cover rear wall 151 and two opposite cover lateral walls 152, 153 to form the inner walls. In other embodiments, the air-guiding channel 18 is adjusted by changing the combination of the second cabinet lateral wall 102 and the cover, and the present disclosure is not limited thereto. Preferably but not exclusively, the vent 16 includes a plurality of through holes or a grid structure, which are disposed on the bottom sides of the cover rear wall 151 and the two opposite cover lateral walls 152, 153, and the bottom wall of the cover 15. In other embodiments, the number, the size and the type of the vent are adjustable, and the present disclosure is not limited thereto.

In the embodiment, the passive damper 2 is disposed in the air-guiding channel 18 and located between the air outlet 13 and the vent 16. In the embodiment, the passive damper 2 includes a hollow frame 20 and a damper blade 21. The hollow frame 20 is combined with the air-guiding channel 18 and communicated up and down. The hollow frame 20 includes a frame front wall 201, a frame rear wall 202 and two opposite frame lateral walls 203 attached to an inner wall surface of the air-guiding channel 18, respectively. That is, the frame front wall 201 is attached to the second cabinet lateral wall 103, the frame rear wall 202 is attached to the cover rear wall 151, and the two opposite frame lateral walls 203, 204 are attached to the two opposite cabinet lateral walls 153, 152, respectively. Preferably but not exclusively, in the embodiment, the hollow frame 20 is connected to the second cabinet lateral wall 102 and the cover 15 by means of screw locking, so as to dispose the hollow frame 20 in the air-guiding channel 18. The manner in which the hollow frame 20 is attached to the second cabinet lateral wall 102 and the cover 15 is adjustable according to the practical requirement, and the present disclosure is not limited thereto. In other embodiments, the hollow frame 20 is attached to the second cabinet lateral wall 102, attached to the three inner walls of the cover 15, and integrally formed with the second cabinet lateral 102 or the cover 15. In those embodiments, after the hollow frame 20 is disposed in the air-guiding channel 18, the air-guiding channel 18 is communicated up and down through the hollow frame 20 merely.

In the embodiment, the damper blade 21 includes a pivoted portion 22, a first end edge 211 and a second end edge 212. Preferably but not exclusively, the damper blade 21 is pivotally arranged between the two opposite frame lateral walls 203, 204 through the pivoted portion 22, and the first end edge 211 and the second end edge 212 are located at two opposite sides of the pivoted portion 22, respectively. In the embodiment, the two pivoted portions 22 corresponding to the frame lateral walls 203, 204 have a rotation axis C, which is offset from a connection line of the first end edge 211 and the second end edge 212. In the embodiment, the first end edge 211 is spatially corresponding to the frame front wall 201, the second end edge 212 is spatially corresponding to the frame rear wall 202, and the first end edge 211 and the second end edge 212 have different torques relative to the pivoted portion 20. In order to make the first end edge 211 and the second end edge 212 have different torques relative to the pivoted portion 22, in the embodiment, a distance from the first end edge 211 to the rotation axis C of the pivoted portion 22 can for example but not limited to be greater than a distance from the second end edge 212 to the rotation axis C of the pivoted portion 22. Similarly, a distance from the rotation axis C of the pivoted portion 22 to the frame front wall 201 is greater than a distance from the rotation axis C of the pivoted portion 22 to the frame rear wall 202. In this way, the torque of the first end edge 211 relative to the pivoted portion 22 is greater than the torque of the second end edge 212 relative to the pivoted portion 22. When the wind pressure of the outdoor environment is less than the wind pressure of the accommodation space 11, the first end edge 211 is rotated to a lower side of the rotation axis C of the pivoted portion 22 under an action of gravity, and the second end edge 212 is rotated to an upper side of the rotation axis C of the pivoted portion 22. At this time, the damper blade 21 is roughly vertical, and the air-guiding channel 18 is kept in communication up and down through the hollow frame 20. It allows the heat-dissipation airflow F1 discharged from the accommodation space 11 through the air outlet 13 to pass smoothly through the air-guiding channel 18 and the hollow frame 20, and then be discharged through the vent 16. The pressure drop of the airflow is not increased, and the flow rate of the heat-dissipation airflow F1 is maintained at a high level.

Notably, the passive damper 2 further includes a pair of limit posts 23 arranged on the two opposite frame lateral walls 203, 204, protruding inwardly, located below the rotation axis C, and offset toward the frame front wall 201 in position. Preferably but not exclusively, the pair of limit posts 23 form an offset angle A1 relative to the rotation axis C and a plumb line, and the offset angle is about 10°. Therefore, when the damper blade 21 is affected by the action of gravity, the first end edge 211 is rotated to a lower side of the rotation axis C of the pivot portion 22, and the first end edge 211 will be blocked by the pair of limit posts 23, so that the damper blade 21 is slightly inclined, and the heat-dissipation airflow F1 is maintained at a relatively high flow rate to pass through. On the other hand, when the wind pressure of the outdoor environment is greater than the wind pressure of the accommodation space 11 and the reverse airflow F2 is generated and introduced to the air-guiding channel 18 from the outdoor environment, the damper blade 21 is slightly inclined due to the action of the limit post 23, and it helps to increase the force area of the damper blade 21 and facilitates the reverse airflow F2 to drive the damper blade 21. Thereby, the reverse airflow F2 can drive the damper blade 21 more easily, the first end edge 211 is driven to abut against the frame front wall 201, and the second end edge 212 is driven to abut against the frame rear wall 202, so as to close the air-guiding channel 18.

In the embodiment, the hollow frame 20 further includes a first blocking element 24 and a second blocking element 25. The first blocking element 24 is disposed on the frame front wall 201, horizontally arranged on the frame front wall 201, and protrudes inwardly from the frame front wall 201. The second blocking element 25 is disposed on the frame rear wall 202, horizontally arranged on the frame rear wall 202, and protrudes inwardly from the frame rear wall 202. In the embodiment, the first blocking element 24 is spatially corresponding to the first end edge 211 of the damper blade 21, and the second blocking element 25 is spatially corresponding to the second end edge 212 of the damper blade 21. When the reverse airflow F2 flows from the outdoor environment into the air-guiding channel 18, the reverse airflow F2 drives the damper blade 21 to rotate, the first end edge 211 is driven to abut against the first blocking element 24 from bottom to top, and the second end edge 212 is driven to abut against the second blocking element 25 from top to bottom, so that the damper blade 21 is indeed connected between the first blocking element 24 on the frame front wall 201 and the second blocking element 25 on the frame rear wall 202, and the air-guiding channel 18 is closed completely.

Notably, in the embodiment, the hollow frame 20 of the passive damper 2 can be regarded as the four-side inner walls of the air-guiding channel 18, which are the same as the second cabinet lateral wall 102, the cover rear wall 151 and two opposite cover lateral walls 152, 153, and collaboratively form an inner wall surface of the air-guiding channel 18. In one embodiment, the passive damper 2 can omit the structure of the hollow frame 20, and the damper blade 21 can be directly arranged between the two opposite cover lateral walls 152, 153 through the pivoted portion 22. Similarly, the pair of limit posts 23 are directly installed on the two opposite cover lateral walls 152, 153, and protrude inwardly into the air-guiding channel 18, so that the pair of limit posts 23 form the aforementioned offset angle A1 relative to the rotation axis C and the plumb line. On the other hand, the first blocking element 24 is horizontally arranged on the second cabinet lateral wall 102 and protrudes inwardly from the second cabinet lateral wall 102 to the air-guiding channel 18. Moreover, the second blocking element 25 is horizontally arranged on the cover rear wall 151, and protrudes inwardly from the cover rear wall 151 to the air-guiding channel 18. In this way, the movement of the damper blade 21 in the air-guiding channel 18 and the performance that can be achieved are the same as those of the aforementioned embodiments, and not redundantly described herein. Notably, in case of that the damper blade 21 of the passive damper 2 is disposed on the air-guiding channel 18 through the hollow frame 20, it is beneficial to product modularization and mass production. Certainly, the damper blade 21 can also be preset on the two opposite cover lateral walls 152, 153 of the cover 15 according to customized requirements, and then combined with the second cabinet lateral wall 102 to form in the air-guiding channel 18. In other embodiments, the damper blade 21 is disposed on the air-guiding channel 18 in other forms. The present disclosure is not limited thereto, and not redundantly describe hereafter.

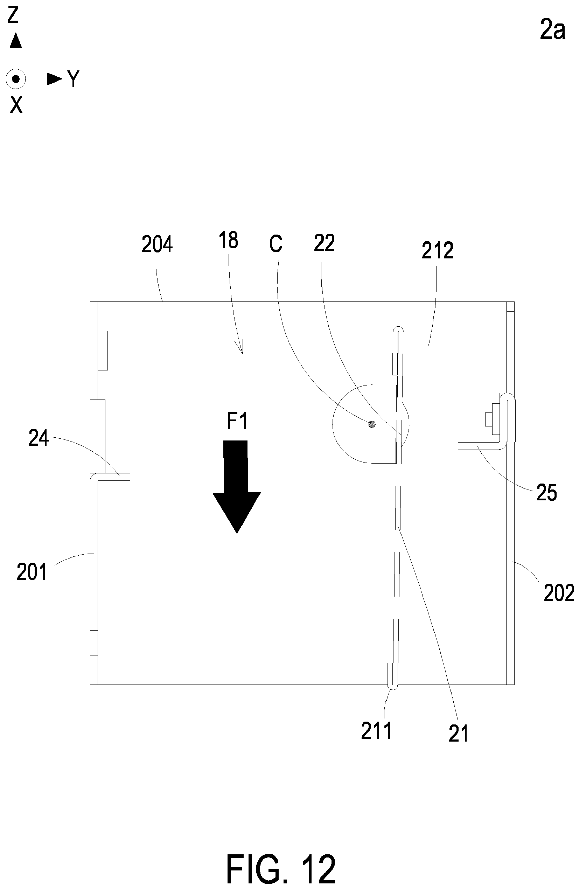

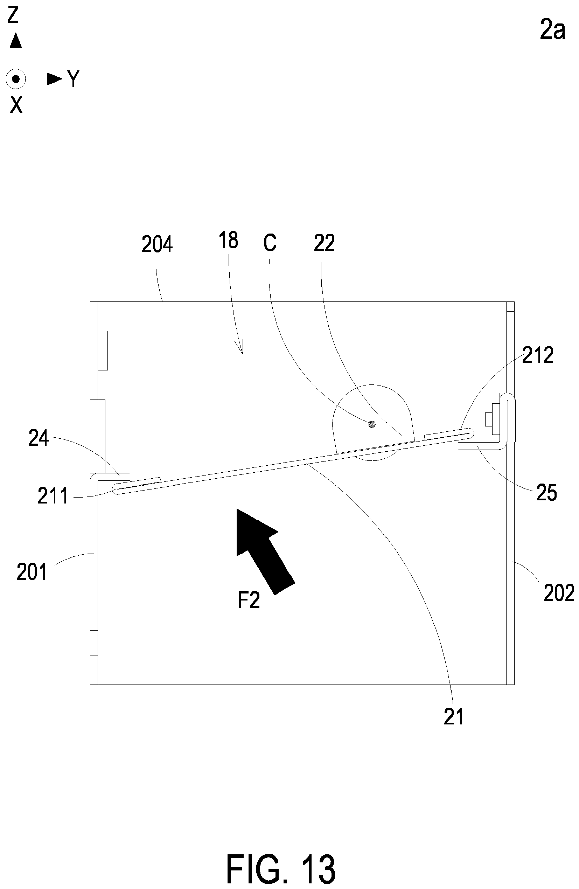

FIG. 12 and FIG. 13 show a second exemplary passive damper of the present disclosure. In the embodiment, the structures, elements and functions of the passive damper 2a are similar to those of the passive damper 2 of the outdoor cabinet 1 with the protective damper in FIG. 1 to FIG. 11, and are not redundantly described herein. Please refer to FIG. 1 to FIG. 13. Different from the passive damper 2 including the limit posts 23 in the foregoing embodiment, in the embodiment, the passive damper 2a omits the structure of the limit posts. When the wind pressure of the outdoor environment is less than the wind pressure of the accommodation space 11, the damper blade 21 is affected by the action of gravity, the first end edge 211 is rotated to a lower side of the rotation axis C of the pivoted portion 22, and the second end edge 212 is rotated to an upper side of the rotation axis C of the pivoted portion 22. In other words, when the damper blade 21 is operated in the normal use state, the damper blade 21 is naturally saggy and roughly parallel to the air-guiding channel 18. The impact on the heat-dissipation airflow F1 passing through the air-guiding channel 18 is minimized, so that that the heat-dissipation airflow F1 with the higher flow rate is maintained. On the other hand, when the wind pressure of the outdoor environment is greater than the wind pressure of the accommodation space 11 and the reverse airflow F2 is generated and introduced to the air-guiding channel 18 from the outdoor environment, the flow direction of the reverse airflow F2 is guided through the design of the vent 16, so as to blow and drive the damper blade 21. In this way, the reverse airflow F2 has sufficient power to drive the damper blade 21 to rotate, the first end edge 211 is driven to abut against the frame front wall 201, and the second end edge 212 is driven to abut against the frame rear wall 202, so as to close the air-guiding channel 18.

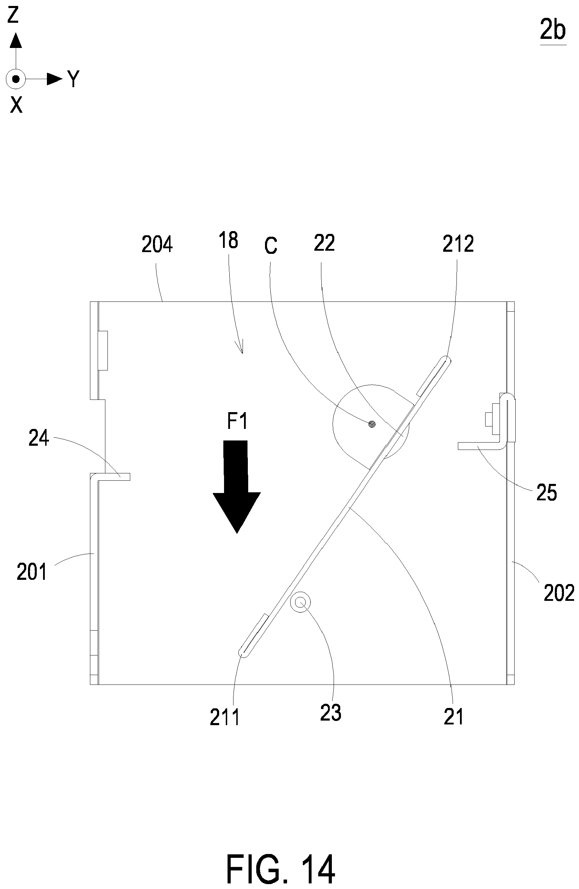

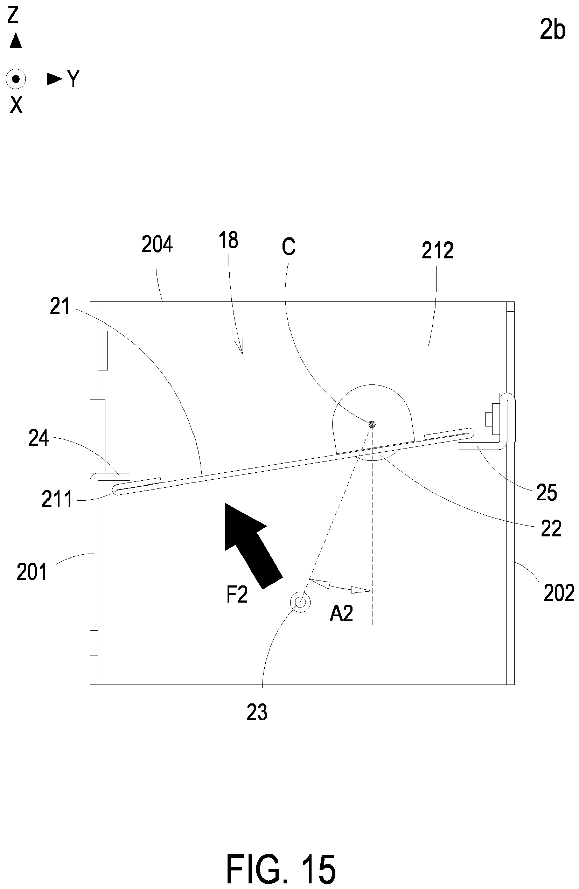

FIG. 14 and FIG. 15 show a third exemplary passive damper of the present disclosure. In the embodiment, the structures, elements and functions of the passive damper 2b are similar to those of the passive damper 2 of the outdoor cabinet 1 with the protective damper in FIG. 1 to FIG. 11, and are not redundantly described herein. Please refer to FIG. 1 to FIG. 11, FIG. 14 and FIG. 15. In the embodiment, the passive damper 2b includes a pair of limit posts 23 arranged on the two opposite frame lateral walls 203, 204, protruding inwardly, located below the rotation axis C, and offset toward the frame front wall 201 in position. Preferably but not exclusively, the pair of limit posts 23 form an offset angle A2 relative to the rotation axis C and a plumb line, and the offset angle is about 20°. When the damper blade 21 is affected by the action of gravity, the first end edge 211 is rotated to a lower side of the rotation axis C of the pivot portion 22, and the first end edge 211 will be blocked by the pair of limit posts 23, so that the damper blade 21 is slightly inclined, and the heat-dissipation airflow F1 is maintained at a relatively high flow rate to pass through. On the other hand, when the wind pressure of the outdoor environment is greater than the wind pressure of the accommodation space 11 and the reverse airflow F2 is generated and introduced to the air-guiding channel 18 from the outdoor environment, the damper blade 21 is slightly inclined due to the action of the limit post 23, and it helps to increase the force area of the damper blade 21 and facilitates the reverse airflow F2 to drive the damper blade 21. Thereby, the reverse airflow F2 can drive the damper blade 21 more easily, the first end edge 211 is driven to abut against the frame front wall 201, and the second end edge 212 is driven to abut against the frame rear wall 202, so as to close the air-guiding channel 18. Certainly, the arrangement of the vent 16 is adjustable according to the practical requirements, so that the reverse airflow F2 can drive the damper blade 21 more easily. Consequently, the first end edge 211 is driven to abut against the frame front wall 201, the second end edge 212 is driven to abut against the frame rear wall 202, and the effect of closing the air-guiding channel 18 is achieved. In other embodiment, the offset angle of the limit posts relative to the rotation axis and a plumb line is ranged from 5° to 45°. It is not redundantly described herein.

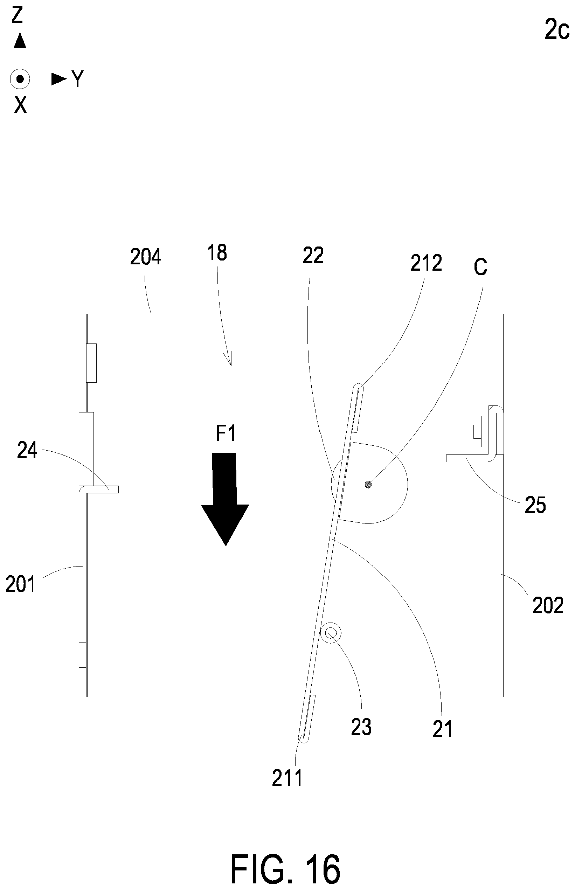

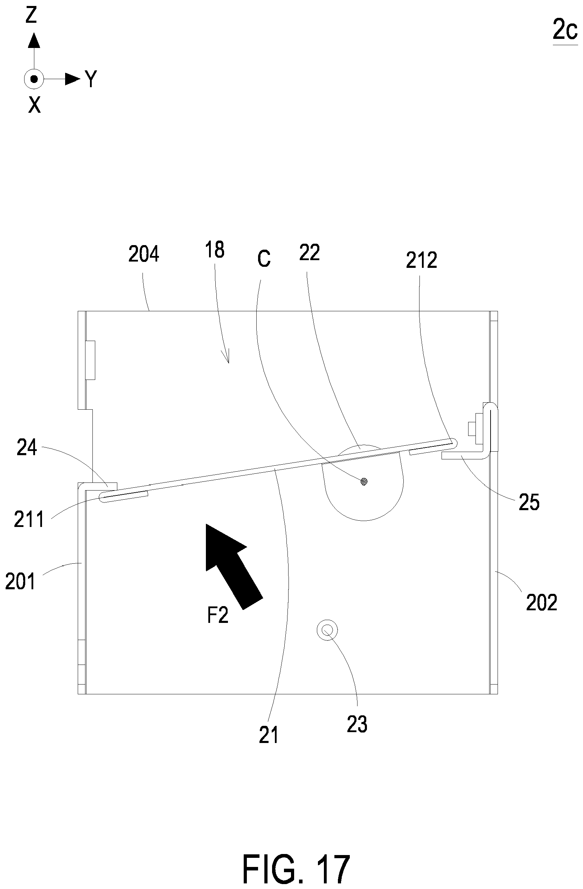

FIG. 16 and FIG. 17 show a fourth exemplary passive damper of the present disclosure. In the embodiment, the structures, elements and functions of the passive damper 2c are similar to those of the passive damper 2 of the outdoor cabinet 1 with the protective damper in FIG. 1 to FIG. 11, and are not redundantly described herein. Please refer to FIG. 1 to FIG. 11, FIG. 16 and FIG. 17. Different from the installation position of the pivoted portion 22 in the passive damper 2 of the previous embodiment, in the embodiment, the passive damper 2c includes the pivoted portion 22 pivotally connected to the damper blade 21 on the other side of the damper blade 21, so as to adjust the torques of the first end edge 211 and the second end edge 212 relative to the pivoted portion 22 and the degree of difficulty of driving the damper blade 21 through the reverse airflow F2. In the normal use state, the damper blade 21 is slight inclined, and the heat-dissipation airflow F1 is maintained at a relatively high flow rate to pass through. Furthermore, when the wind pressure of the outdoor environment is greater than the wind pressure of the accommodation space 11 and the reverse airflow F2 is generated and introduced to the air-guiding channel 18 from the outdoor environment, the reverse airflow F2 has sufficient power to drive the damper blade 21 to rotate, the first end edge 211 is driven to abut against the frame front wall 201, and the second end edge 212 is driven to abut against the frame rear wall 202, so as to close the air-guiding channel 18.

Notably, in the foregoing embodiments, many technical features can be combined and changed to form an application in which the passive damper blade 21 are arranged in the air-guiding channel 18. In the normal use state, the air-guiding channel 18 is opened to maintain the high flow rate of the heat-dissipation airflow F1 passing therethrough. Moreover, under the wind-driven rain weather conditions, the wind pressure effect generated by the storm is utilized to close the air-guiding channel 18 and implement the protection, so that the effect of completely preventing the storm from pouring back to the air outlet 13 or entering the cabinet 10 is achieved. In those embodiments, the sizes, the positions and the relationships of the vent 16, the hollow frame 20, the damper blade 21, the pivoted portion 22, the limit posts, the first blocking element 24 and the second blocking element 25 are adjustable according to the practical requirements, so as to achieve the optimization of wind-driven rain ingression protection. The arrangements of the vent 16, the hollow frame 20, the damper blade 21, the pivoted portion 22, the limit posts, the first blocking element 24 and the second blocking element 25 are not limited to the illustrated embodiments, and not redundantly described hereafter.

In summary, the present disclosure provides an outdoor cabinet with a protective damper. A passive damper is disposed adjacent to the air outlet of the outdoor power-supply air-cooled cooling cabinet. During normal use, the passive damper is opened to maintain the heat-dissipation airflow of the cabinet. Under the wind-driven rain weather conditions, the passive damper is closed by the wind pressure, so as to provide the protection and completely prevent the storm from pouring back to the air outlet or entering the cabinet. With a passive damper disposed in the air-guiding channel communicated up and down, the heat-dissipation airflow volume is sufficiently maintained during normal use, and 100% blocking of the storm is ensured to prevent the storm from pouring back to the air outlet or entering the cabinet under the wind-driven rain weather conditions. The passive damper blade can be installed through a hollow frame or directly installed in the air-guiding channel. There is no need to use other waterproof air filters to prevent the storm from pouring back. Consequently, the installation is simplified and the design cost is reduced. On the other hand, since the damper blade is installed and pivoted to the air-guiding channel through ball bearings or pin bearings, it allows to keep the end edge of the damper blade saggy within a specific angle range by using the force of gravity and cooperating with the limit columns. In this way, the internal heat-dissipation airflow can flow through the damper blade smoothly. Compared with the conventional complex fixed structure for preventing the storm from pouring back through the vent, the passive damper of the present disclosure is disposed in the air-guiding channel to keep open during normal use, without increasing the air pressure drop, so that the heat-dissipation airflow is maintained at a high flow rate. Moreover, under the wind-driven rain weather conditions, the wind pressure in the outdoor environment is greater than the wind pressure in the cabinet and a reverse airflow is generated to flow from the outdoor environment through the vents and enters the air-guiding channel. In this way, the reverse airflow can easily drive the damper blade to close the air-guiding channel, and the effect of completely preventing the storm from pouring back to the air outlet through the vents or entering the cabinet is achieved.

## Claims

1. An outdoor cabinet (1) with a protective damper **characterized by** comprising:
a cabinet (10) comprising an air inlet (12) and an air outlet (13), wherein the air inlet (12) is disposed on a first cabinet lateral wall (101) of the cabinet (10), the air outlet (13) is disposed on a second cabinet lateral wall (102) of the cabinet (10), and the first cabinet lateral wall (101) and the second cabinet lateral wall (102) are corresponding to each other;
an active damper (3) disposed on the first cabinet lateral wall (101) and arranged adjacent to the air inlet (12); and
a passive damper (2, 2a, 2b, 2c) disposed on the second cabinet lateral wall (102) and comprising an exhaust fan (40) and a damper blade (21), wherein the exhaust fan (40) is disposed adjacent to the air outlet (13), and the damper blade (21) is disposed outside the air outlet (13) for closing or opening the air outlet (13),
wherein the exhaust fan (40) is operated to generate a heat-dissipation airflow (F1) flowing inside the cabinet (10) from the air inlet (12) to the air outlet (13), and the damper blade (21) allows the heat-dissipation airflow (F1) to be discharged from the air outlet (13);
wherein when a wind pressure outside the cabinet (10) is greater than a wind pressure inside the cabinet (10) and a reverse airflow (F2) is generated, the reverse airflow (F2) drives the damper blade (21) to close the air outlet (13) for protecting electronic devices (9) installed in the cabinet (10).

2. The outdoor cabinet (1) with the protective damper according to claim 1, further comprising a cover (15) covering the air outlet (13) of the cabinet (10) and collaboratively forming an air-guiding channel (18) with the second cabinet lateral wall (102), wherein the air-guiding channel (18) is communicated up and down, and includes an upper part of the air-guiding channel (18) in communication with an accommodation space (11) in the cabinet (10) through the air outlet (13), and a lower part of the air-guiding channel (18) in communication with an outdoor environment outside the cabinet (10) through a vent (16), wherein the passive damper (2, 2a, 2b, 2c) is disposed in the air-guiding channel (18).

3. The outdoor cabinet (1) with the protective damper according to claim 2, wherein the passive damper (2, 2a, 2b, 2c) comprises a hollow frame (20) communicated up and down, and the hollow frame (20) comprises a frame front wall (201), a frame rear wall (202) and two opposite frame lateral walls (203, 204) attached to an inner wall surface of the air-guiding channel (18), respectively, wherein the damper blade (21) comprises a pivoted portion (22), a first end edge (211) and a second end edge (212), the damper blade (21) is pivotally arranged between the two opposite frame lateral walls (203, 204) through the pivoted portion (22), and the first end edge (211) and the second end edge (212) are located at two opposite sides of the pivoted portion (22), respectively, wherein the first end edge (211) is spatially corresponding to the frame front wall (201), the second end edge (212) is spatially corresponding to the frame rear wall (202), and the first end edge (211) and the second end edge (212) have different torques relative to the pivoted portion (22), wherein when the wind pressure of the outdoor environment is greater than the wind pressure of the accommodation space (11) and the reverse airflow (F2) is generated to flow from the outdoor environment into the air-guiding channel (18), the reverse airflow (F2) drives the damper blade (21) to rotate, the first end edge (211) is driven to abut against the frame front wall (201), and the second end edge (212) is driven to abut against the frame rear wall (202), so as to close the air-guiding channel (18).

4. The outdoor cabinet (1) with the protective damper according to claim 3, wherein the frame front wall (201) of the hollow frame (20) is attached to the second cabinet lateral wall (102), the frame rear wall (202) and the two opposite frame lateral walls (203, 204) are attached to three inner walls of the cover (15), and the hollow frame (20) is located between the air outlet (13) and the vent (16), wherein the pivoted portion (22) is pivotally connected to the two opposite frame lateral walls (203, 204) through a ball bearing or a PIN bearing.

5. The outdoor cabinet (1) with the protective damper according to claim 3, wherein the hollow frame (20) further comprises a first blocking element (24) and a second blocking element (25), the first blocking element (24) is horizontally arranged on the frame front wall (201) and protrudes inwardly from the frame front wall (201), and the second blocking element (25) is horizontally arranged on the frame rear wall (202) and protrudes inwardly from the frame rear wall (202), wherein the first blocking element (24) is spatially corresponding to the first end edge (211) of the damper blade (21), and the second blocking element (25) is spatially corresponding to the second end edge (212) of the damper blade (21), wherein when the reverse airflow (F2) flows from the outdoor environment into the air-guiding channel (18), the reverse airflow (F2) drives the damper blade (21) to rotate, the first end edge (211) is driven to abut against the first blocking element (24), and the second end edge (212) is driven to abut against the second blocking element (25), so as to close the air-guiding channel (18).

6. The outdoor cabinet (1) with the protective damper according to claim 3, wherein the pivoted portion (22) has a rotation axis (C) offset from a connection line between the first end edge (211) and the second end edge (212), wherein a distance from the first end edge (211) to the rotation axis (C) is greater than a distance from the second end edge (212) to the rotation axis (C), a distance from the rotation axis (C) to the frame front wall (201) is greater than a distance from the rotation axis (C) to the frame rear wall (202), and a torque of the first end edge (211) relative to the rotation axis (C) is greater than a torque of the second end edge (212) relative to the rotation axis (C), wherein when the wind pressure of the outdoor environment is less than the wind pressure of the accommodation space (11), the first end edge (211) is rotated to a lower side of the rotation axis (C) under an action of gravity, wherein the passive damper (21) further comprises a pair of limit posts (23) arranged on the two opposite frame lateral walls (203, 204), protruding inwardly, located below the rotation axis (C), and offset toward the frame front wall (201), wherein the pair of limit posts (23) form an offset angle (A1, A2) relative to the rotation axis and a plumb line, and the offset angle (A1, A2) is ranged from 5° to 45°.

7. The outdoor cabinet (1) with the protective damper according to claim 1, wherein the active damper (3) further comprises an inflow fan (30) arranged adjacent to the air inlet (12).

8. An outdoor cabinet (1) with a protective damper **characterized by** comprising:
a cabinet (10) comprising a first cabinet lateral wall (101) and a second cabinet lateral wall (102) corresponding to each other, an air inlet (12), an air outlet (13) and an accommodation space (11), wherein the air inlet (12) is disposed on the first cabinet lateral wall (101), the air outlet (13) is disposed on the second cabinet lateral wall (102), and the accommodation space (11) is in communication with the air inlet (12) and the air outlet (13);
an active damper (3) disposed on the first cabinet lateral wall (101) and configured to form a heat-dissipation airflow (F1) inhaled through the air inlet (12) and discharged through the air outlet (13);
a cover (15) covering the air outlet (12) and collaboratively forming an air-guiding channel (18) with the second cabinet lateral wall (102), wherein the air-guiding channel (18) is communicated up and down, and includes an upper part of the air-guiding channel (18) in communication with the accommodation space (11) through the air outlet (12), and a lower part of the air-guiding channel (18) in communication with an outdoor environment through a vent (16); and
a passive damper (2, 2a, 2b, 2c) disposed in the air-guiding channel (18), and comprising:
a hollow frame (20) communicated up and down, and comprising a frame front wall (201), a frame rear wall (202) and two opposite frame lateral walls (203, 204) attached to an inner wall surface of the air-guiding channel (18), respectively, and
a damper blade (21) comprising a pivoted portion (22), a first end edge (211) and a second end edge (212), wherein the damper blade (21) is pivotally arranged between the two opposite frame lateral walls (203, 204) through the pivoted portion (22), and the first end edge (211) and the second end edge (212) are located at two opposite sides of the pivoted portion (22), respectively, wherein the first end edge (211) is spatially corresponding to the frame front wall (201), the second end edge (212) is spatially corresponding to the frame rear wall (202), and the first end edge (211) and the second end edge (212) have different torques relative to the pivoted portion (22), wherein when a wind pressure of the outdoor environment is greater than a wind pressure of the accommodation space and a reverse airflow (F2) is generated to flow from the outdoor environment into the air-guiding channel (18), the reverse airflow (F2) drives the damper blade (21) to rotate, the first end edge (211) is driven to abut against the frame front wall (201), and the second end edge (212) is driven to abut against the frame rear wall (202), so as to close the air-guiding channel (18).

9. The outdoor cabinet (1) with the protective damper according to claim 8, wherein the vent (16) is arranged adjacent to a bottom side of the cover (15), the air-guiding channel (18) is in communication between the air outlet (13) and the vent (16), and a horizontal height of the air outlet (13) higher than a horizontal height of the vent (16).

10. The outdoor cabinet (1) with the protective damper according to claim 9, wherein the frame front wall (201) of the hollow frame (20) is attached to the second cabinet lateral wall (102), the frame rear wall (202) and the two opposite frame lateral walls (203, 204) are attached to three inner walls of the cover (13), and the hollow frame (20) is located between the air outlet (13) and the vent (16), wherein the pivoted portion (22) is pivotally connected to the two opposite frame lateral walls (203, 204) through a ball bearing or a PIN bearing.

11. The outdoor cabinet (1) with the protective damper according to claim 8, wherein the hollow frame (20) further comprises a first blocking element (24) and a second blocking element (25), the first blocking element (24) is horizontally arranged on the frame front wall (201) and protrudes inwardly from the frame front wall (201), and the second blocking element (25) is horizontally arranged on the frame rear wall (202) and protrudes inwardly from the frame rear wall (202), wherein the first blocking element (24) is spatially corresponding to the first end edge (211) of the damper blade (21), and the second blocking element (25) is spatially corresponding to the second end edge (212) of the damper blade (21), wherein when the reverse airflow (F2) flows from the outdoor environment into the air-guiding channel (18), the reverse airflow (F2) drives the damper blade (21) to rotate, the first end edge (211) is driven to abut against the first blocking element (24), and the second end edge (212) is driven to abut against the second blocking element (25), so as to close the air-guiding channel (18).

12. The outdoor cabinet (1) with the protective damper according to claim 8, wherein the pivoted portion (22) has a rotation axis (C) offset from a connection line between the first end edge (211) and the second end edge (212), wherein a distance from the first end edge (211) to the rotation axis (C) is greater than a distance from the second end edge (212) to the rotation axis (C), a distance from the rotation axis (C) to the frame front wall (201) is greater than a distance from the rotation axis (C) to the frame rear wall (202), and a torque of the first end edge (211) relative to the rotation axis (C) is greater than a torque of the second end edge (212) relative to the rotation axis (C), wherein when the wind pressure of the outdoor environment is less than the wind pressure of the accommodation space, the first end edge (211) is rotated to a lower side of the rotation axis (C) under an action of gravity.

13. The outdoor cabinet (1) with the protective damper according to claim 12, wherein the passive damper (21) further comprises a pair of limit posts (23) arranged on the two opposite frame lateral walls (203, 204), protruding inwardly, located below the rotation axis (C), and offset toward the frame front wall (201) in position, wherein the pair of limit posts (23) form an offset angle (A1, A2) relative to the rotation axis (C) and a plumb line, and the offset angle (A1, A2) is ranged from 5° to 45°.

14. An outdoor cabinet (1) with a protective damper **characterized by** comprising:
a cabinet (10) comprising a first cabinet lateral wall (101) and a second cabinet lateral wall (102) corresponding to each other, an air inlet (12), an air outlet (13) and an accommodation space (11), wherein the air inlet (12) is disposed on the first cabinet lateral wall (101), the air outlet (13) is disposed on the second cabinet lateral wall (102), and the accommodation space (11) is in communication with the air inlet (12) and the air outlet (13);
an active damper (3) disposed on the first cabinet lateral wall (101) and configured to form a heat-dissipation airflow (F1) inhaled through the air inlet (12) and discharged through the air outlet (13);
a cover (15) connected to the second cabinet lateral wall (102), covering the air outlet (12) and collaboratively forming an air-guiding channel (18) with the second cabinet lateral wall (102), wherein the air-guiding channel (18) is communicated up and down, and includes an upper part of the air-guiding channel (18) in communication with the accommodation space (11) through the air outlet (13), and a lower part of the air-guiding channel (18) in communication with an outdoor environment through a vent (16), wherein the cover (15) comprises a cover rear lateral wall (151) and two opposite cover lateral walls (152, 153), and the cover (15) is connected to the second cabinet lateral wall (102) through the two opposite cover lateral walls (152, 153), respectively; and
a passive damper (2, 2a, 2b, 2c) comprising a damper blade (21), a pivoted portion (22), a first end edge (211) and a second end edge (212), wherein the damper blade (21) is pivotally arranged between the two opposite cover lateral walls (152,153) through the pivoted portion (22), and the first end edge (211) and the second end edge (212) are located at two opposite sides of the pivoted portion (22), respectively, wherein the first end edge (211) is spatially corresponding to the second cabinet lateral wall (102), the second end edge (212) is spatially corresponding to the cover rear wall (151), and the first end edge (211) and the second end edge (212) have different torques relative to the pivoted portion (22), wherein when a wind pressure of the outdoor environment is greater than a wind pressure of the accommodation space and a reverse airflow (F2) is generated to flow from the outdoor environment into the air-guiding channel (18), the reverse airflow (F2) drives the damper blade (21) to rotate, the first end edge (211) is driven to abut against the second cabinet lateral wall (102), and the second end edge is driven to abut against the frame rear wall, so as to close the air-guiding channel (18).

15. The outdoor cabinet (1) with the protective damper according to claim 14, wherein the cabinet (10) further comprises a deflector (17) connected to a lower edge of the air outlet (13), protruding toward the air-guiding channel (18), and forming an acute angle with the second cabinet lateral wall (102), wherein the deflector (17) is configured to guide the heat-dissipation airflow (F1) into the air-guiding channel (18).
